# EUROPÄISCHE PATENTSCHRIFT

(11) **EP 2 567 928 B1**
(45) Veröffentlichungstag und Bekanntmachung des Hinweises auf die Patenterteilung: **11.09.2013**
(21) Anmeldenummer: 11008340.9
(22) Anmeldetag: 17.10.2011
(51) Int. Cl.: B66B 13/22, H03K 17/968

(54) **Sensor, Sicherungsvorrichtung sowie Aufzugvorrichtung**
Sensor, safety device and lift device
Capteur, dispositif de sécurisation et dispositif d'ascenseur

(30) Priorität: 06.09.2011 EP 11007224
(43) Veröffentlichungstag der Anmeldung: 13.03.2013
(73) Patentinhaber: Cedes AG, 7302 Landquart (CH)
(72) Erfinder: De Coi, Beat, 7320 Sargans (CH); Leutenegger, Tobias, Dr., 7000 Chur (CH); Hersche, Dumeng, 7402 Bonaduz (CH); Hegelbach, Jürg, 9463 Oberriet (CH)
(74) Vertreter: Otten, Roth, Dobler & Partner

(56) Entgegenhaltungen:
- DE-C- 550 716
- GB-A- 876 371
- GB-A- 2 246 196

## Beschreibung

Die Erfindung betrifft einen Sensor für Sicherungsvorrichtungen für Aufzugvorrichtungen nach dem Oberbegriff des Anspruchs 1, eine Sicherungsvorrichtung für Aufzugvorrichtungen nach dem Oberbegriff des Anspruchs 15, eine Sicherungsvorrichtung für Aufzugvorrichtung nach dem Oberbegriff des Anspruchs 18.

Bekannt sind aus dem Stand der Technik handelsübliche Sicherungsvorrichtungen für Aufzüge, welche elektrische bzw. elektromechanische Kontakte und Schalter verwenden, um den Verriegelungs- bzw. Schließzustand einer Aufzugstür zu bestimmen. Die Fahrt einer Aufzugkabine soll dabei nur zugelassen werden, wenn sämtliche Türen verriegelt sind.

Aus GB 876 371 ist einen Sensor nach dem Oberbegriff von Anspruch 1 bekannt.

Aufgabe der Erfindung ist es, einen Sensor, eine Sicherungsvorrichtung sowie eine Aufzugvorrichtung vorzuschlagen, bei denen die Wartungsanfälligkeit verbessert werden kann.

Die Aufgabe wird, ausgehend von einem Sensor, einer Sicherungsvorrichtung sowie eine Aufzugvorrichtung der eingangs genannten Art, durch die kennzeichnenden Merkmale der Ansprüche 1, 14 und 17 gelöst.

Durch die in abhängigen Ansprüchen genannten Maßnahmen sind vorteilhafte Weiterbildungen und Ausführungen der Erfindung möglich.

Dementsprechend zeichnet sich ein erfindungsgemäßer Sensor für Sicherungsvorrichtungen für Aufzugvorrichtungen, die über einen Antrieb eine Kabine verfahren können, dadurch aus, dass der Sensor als optischer Sensor ausgebildet ist, der einen Sender zum Senden eines optischen Signals und einen Empfänger zum Empfangen des optischen Signals umfasst. Besonders vorteilhaft ist an dem erfindungsgemäßen Sensor, dass dieser berührungslos, dass heißt auch verschleißfrei arbeiten kann. Zudem weist der erfindungsgemäße Sensor somit keine oder weniger spannungsführende Kontaktflächen auf und ist darüber hinaus montagesicher. Der erfindungsgemäße Sensor kann deshalb einen handelsüblichen Schalter, einen sog. Interlock switch, aus dem Stand der Technik ersetzen.

Zudem ermöglicht der erfindungsgemäße Sensor, dass im Gegensatz zu einem elektromechanischen Schalter keine Unterbrechung des Stromkreises erfolgen muss. In vorteilhafter Weise kann durch den erfindungsgemäßen Sensor auch ein Defekt vermieden werden, der z. B. bei elektromechanischen Sensoren und Kontakten durch Kontaktbrand infolge von Funkenüberschlag beim Öffnen bzw. Schließen der elektrischen Kontakte erfolgen und schließlich zum Funktionsverlust führen kann. Folglich kann die Wartungsanfälligkeit durch den erfindungsgemäßen Sensor verbessert werden.

Dadurch, dass bei einem erfindungsgemäßen Sensor der Stromkreis im Gegensatz zu einem Schalter nicht unterbrochen werden muss, ist in vorteilhafter Weise eine verbesserte Diagnose bei Defekten möglich.

Erfindungsgemäß sind eine Kontaktbrücke und ein Kontaktnehmer zur Aufnahme der Kontaktbrücke vorgesehen, welche so angeordnet sind, dass der Schließzustand der Aufzugstür durch Verbindung von Kontaktnehmer und Kontaktbrücke bestimmbar ist. Der Detektionszustand des Sensors hängt daher von der Annäherung der Kontaktbrücke an den Kontaktnehmer ab.

Ein Aufzug selbst besitzt im Allgemeinen zum einen eine Kabine, welche zwischen einzelnen Stockwerken bzw. Etagen verfahren werden kann. Die einzelnen Etagen besitzen jeweils Schachtöffnungen, in deren Bereich die Kabine in eine Halteposition gefahren werden kann, wenn diese die entsprechende Etage anfahren soll. In dieser Halteposition wird dann ein Zugang zur Kabine ermöglicht. Dieser Zugang kann dadurch ermöglicht werden, dass die Aufzugtüren geöffnet und dann vor der Weiterfahrt wieder geschlossen und verriegelt werden. Aufzugtüren können Schachttüren oder Kabinentüren sein. Die Schachttüren sind im Bereich der Schachtöffnung am Schacht selbst befestigt bzw. verfahrbar gelagert. Die Kabinentüren wiederum sind an der Kabine befestigt und fahrbar gelagert. Regelmäßig ist einer Schachttür jeweils eine Kabinentür zugeordnet, wobei beide in Halteposition überlappend (zumindest teilweise überlappend) angeordnet sind. Regelmäßig werden diese auch zumindest im Wesentlichen synchron verfahren.

Damit eine Fahrt in der Kabine aufgenommen werden kann bzw. die Kabine weiter in Fahrt bleiben kann, ist es notwenig, dass sämtliche Türen verschlossen und verriegelt sind. Dies kann über entsprechende Sicherungsvorrichtungen überprüft werden, welche mittels einer Unterbrechervorrichtung gegebenenfalls den Antrieb stoppen kann. Grundsätzlich kann die Unterbrechungsvorrichtung bzw. Unterbrechungskreis die Kontrolleinheit, d. h. Steuerung bzw. Regelung, des Motors bzw. des Antriebs ansprechen, sodass diese den Antrieb stoppt, denkbar ist auch dass die Unterbrechungsvorrichtung direkt die Stromversorgung des Antriebs / Motors unterbricht.

Der entsprechende Sensor ist somit dafür ausgebildet, zu überprüfen, ob die entsprechende Tür eines Aufzugs bzw. eines Schachts offen oder geschlossen und verriegelt ist. Vorliegend ist es besonders vorteilhaft, den Sensor ähnlich einer Steckverbindung auszubilden, sodass eine Kontaktbrücke in einen Kontaktschacht eingreifen kann. Zudem ermöglicht diese Maßnahme eine mechanisch sehr stabile Vorrichtung. Grundsätzlich kann ein Sensor gemäß der Erfindung so ausgebildet sein, dass die Kontaktbrücke mit Spiel oder formschlüssig in den Schacht des Kontaktnehmers aufgenommen wird.

Ferner ist erfindungsgemäß die Kontaktbrücke so ausgebildet, dass sie wenigstens ein Übertragungselement zur Übertragung eines optischen Signals umfasst. Hierdurch kann insbesondere in vorteilhafter Weise eine sogenannte Fail-safe-Schaltung, also eine ausfallsichere Schaltung erreicht werden. Lediglich dann, wenn die Kontaktbrücke durch entsprechende Verbindung mit dem Kontaktnehmer beim Schließen der Tür eine spezielle Position erreicht hat, kann eine entsprechende Freigabe für die Fahrt erteilt werden. Bei einer bloßen Lichtschranke wäre dies grundsätzlich nicht der Fall: Das Übertragungselement kann nämlich so ausgebildet sein, dass die Übertragung des optischen Signals auf eine spezielle Art und Weise erfolgt, die nur sehr schwer manipuliert werden kann und auch nicht zufällig ohne weiteres realisiert wird. Würde es sich beispielsweise um eine bloße Lichtschranke handeln, welche beim Schließen der Tür unterbrochen würde, so würde dies bedeuten, dass der Antrieb auch dann freigegeben würde, wenn z. B. ein entsprechender Gegenstand, eine Fliege oder Ähnliches die Lichtschranke unterbricht.

Es bietet sich außerdem an, den Sender bzw. den Empfänger am Kontaktnehmer anzuordnen. Die Übertragung des Lichts über das Übertragungselement kann dann lediglich über die Kontaktbrücke erfolgen. Durch diese Ausbildung wird eine besonders kompakte Bauweise ermöglicht.

Eine Möglichkeit besteht darin, das Übertragungselement als Reflexionsfläche auszubilden, wobei diese dann das optische Signal bzw. das Licht reflektiert und nur so auf den entsprechenden Empfänger leitet. Die Reflexionsfläche kann zum Beispiel in einer Kerbe in der Kontaktbrücke angeordnet sein. Denkbar ist jedoch ferner, dass es sich bei dem Übertragungselement um ein optisches Medium handelt. Denkbar ist beispielsweise, dass die Lichtbrechung beim Übergang von der Luft in dieses optische Medium ausgenutzt wird und der Lichtstrahl somit in eine gewisse Richtung gelenkt wird, sodass nur dann entweder auf dem Empfänger oder gerade nicht auf den Empfänger geleitet wird.

Als optisches Medium kann ferner bei einer Ausführungsform der Erfindung ein Lichtleiter vorgesehen sein. Das optische Signal wird dann übertragen, wenn dessen Licht in den Lichtleiter eingekoppelt wird, durch den Lichtleiter propagiert und über den Lichtleiter in den Empfänger gelangt.

Besonders vorteilhaft ist es, den Sender als Leuchtdiode und/oder dem Empfänger als Photodiode auszubilden. Es handelt sich dabei um besonders günstige Standardelektronikbauteile; hierdurch können insbesondere Kosten eingespart werden.

Damit kein Streulicht zufällig von Sender in den Empfänger gelangt, kann zusätzlich ein Trennelement, insbesondere einen Trennsteg zur optischen Trennung von Sender und Empfänger vorgesehen sein. Dies verringert noch einmal grundsätzlich die Möglichkeit, dass Fehler aufgrund einer falschen Interpretation der Signale auftreten. Zusätzlich kann im Übrigen auch ein Diffusor vorgesehen sein, welcher Streulicht diffus verbreitet. Denkbar ist ferner, dass der Empfänger bei der Detektion auf einen gewissen Schwellwert hinsichtlich der Intensität des einfallenden Lichtes eingestellt wird, sodass bei einer gewissen Menge von Streulicht, die gegebenenfalls in den Empfänger hineinfällt, nicht dennoch ein entsprechendes Folgesignal ausgelöst wird, welches lediglich dann aufgelöst werden sollte, wenn über das Übertragungselement Licht in dem Empfänger fällt.

Um die Sicherheit der Vorrichtung noch einmal erhöhen zu können, kann eine Ausführungsform so ausgestaltet sein, dass die Wahrscheinlichkeit einer zufälligen Reflexion, mit der das Signal vom Sender und zum Empfänger im Kontaktnehmer gelangt, möglichst gering ist. Eine Möglichkeit dafür besteht darin, dass das Signal des Senders nicht über eine einzige Reflexion zum Empfänger geleitet werden kann, also ein spezieller optischer Weg notwendig ist. Insbesondere ist der Sender und der Empfänger so angeordnet, dass das Signal des Senders über mindestens zwei Reflexionen zum Empfänger geführt werden muss. Denkbar ist auch eine Kombination von Reflexionen und der Einkopplung in einen Lichtleiter, sodass das Licht reflektiert wird und dann eine bestimmte Strecke durch einen Lichtleiter propagieren muss. Auch eine spezielle Einkopplung, z.B. durch eine Linse kann notwendig sein. Denkbar ist auch, dass, wie z.B. beim Konzept eines Schachtes mit einer dort einzuführenden Lasche, der Sensor so abgeschirmt ist, dass die Reflexion praktisch nicht zufällig erfolgen kann. Ferner besteht die Möglichkeit, den Schwellwert im Empfänger so hoch zu setzen, dass nur eine entsprechende Reflexion durch eine Reflexionseinheit ein Signal hervorruft, wodurch die Schwelle überschritten werden kann.

Insbesondere ist die Kontaktbrücke ausgebildet das Signal des Senders über 4 Reflexionen zum Empfänger zu führen.

Im Übrigen ist grundsätzlich auch denkbar, dass der Kontaktnehmer Übertragungselemente zur Übertragung des optischen Signals umfasst, z.B. Reflexionsflächen oder optische Medien wie z.B. Lichtleiter. Denkbar ist, dass eine Teilstrecke des Propagationsweges des optischen Signals vom Sender zum Empfänger über eine Reflexionsfläche bzw. durch einen Lichtleiter im Kontaktnehmer erfolgt. Denkbar ist auch, dass durch Aufnahme der Kontaktbrücke der Lichtleiter im Kontaktnehmer oder in der Kontaktbrücke so verschoben wird, dass eine Übertragung des Lichts ermöglicht wird.

Besonders robust kann beispielsweise eine Verbindung hergestellt werden, bei der der Kontaktnehmer einen Schacht und die Kontaktbrücke eine zungenförmige Lasche umfasst, welche bei Verbindung von Kontaktbrücke und Kontaktnehmer in den Schacht eingreift. Besonders vorteilhaft ist dabei auch, dass eine entsprechende Codierung vorgenommen werden kann, dass heißt, dass die Kontaktbrücke, ähnlich wie ein Schlüssel, besonders ausgebildet sein muss, damit sie in den Kontaktnehmer eindringen kann. Dies kann insbesondere die Sicherheit dieser Vorrichtung erhöhen, insbesondere dann, wenn der Kontaktnehmerschacht so ausgebildet ist, dass keine Hand eindringen kann.

Bei einer besonders bevorzugten Ausführungsform der Erfindung sind wenigstens zwei Übertragungselemente vorgesehen, welche in Bewegungsrichtung der Kontaktbrücke hintereinander angeordnet sind, das bedeutet, dass beim Verriegeln der Tür die Kontaktbrücke entsprechend in den Kontaktnehmer eintaucht und zunächst für das optische Signal bzw. den optischen Lichtstrahl eines der Übertragungselemente (nämlich das erste in Bewegungsrichtung) sichtbar wird. Beim weiterschieben wird anschließend das nächste Übertragungselement sichtbar, während das vorangegangene aus dem optischen Weg heraus geschoben wird. Es können somit zeitlich versetzt mehrere optische Signale auftreten. Ferner ist es denkbar, eine zugehörige Auswerteeinheit oder Elektronikeinheit so auszubilden, dass beispielsweise das Auftreten der entsprechenden Signale in Abhängigkeit von der Zeit ermittelt wird. Darüber können Rückschlüsse über die Geschwindigkeit der Verriegelung ermittelt werden. Dies ermöglicht auch einen Rückschluss auf den Funktions- und Wartungszustand der Verriegelungseinrichtung der Türe. Grundsätzlich wird im Übrigen die Verriegelung, nicht der Türschluss überwacht. Je nach dem, wie die entsprechenden Übertragungselemente angeordnet sind bzw. wie viele der Übertragungselemente angeordnet sind, kann gegebenenfalls die Präzision einer solchen Bestimmung erhöht werden.

Des Weiteren kann der Sensor bei einer Ausführungsform der Erfindung eine Elektronikeinheit zur Auswertung des Empfängers umfassen, welche dazu ausgebildet ist, die Auswertung des Empfängers in einen der Schaltzustände und/oder in ein elektrisches Signal zu interpretieren. Dies bedeutet, dass die Elektronikeinheit dazu ausgebildet ist, ein elektrisches Signal zu erzeugen, und zwar in Abhängigkeit davon, was der Empfänger detektiert. Je nach Detektion des Empfängers, ist es notwendig, einen Schaltzustand herzustellen oder gegebenenfalls beizubehalten. Die Änderung eines Schaltzustandes kann z.B. durch Erzeugung eines elektrischen Signals in Abhängigkeit von der Detektion des Empfängers erfolgen.

Da im Übrigen der mechanische Schließzustand auf rein optischem Wege detektiert wird, bedeutet dies, dass nicht zwingend wieder eine Herstellung eines mechanischen Kontaktes oder eines mechanischen Öffnungszustandes notwendig ist, um ein elektrisches Signal zu erhalten. Denkbar ist beispielsweise, dass das optische Signal den Empfänger, beispielsweise eine Photodiode, durchschaltet und somit ein Leitungszustand (im Gegensatz zu einer Unterbrechung) erreicht werden kann. Hierdurch wird gewissermaßen elektronisch eine Interpretation des Schaltzustandes des Sensors durchgeführt. Die Elektronikeinheit kann allerdings auch zusätzlich dazu ausgebildet sein, eine Anbindung an weitere Elektronik zu ermöglichen. Beispielsweise kann sie auch dazu ausgebildet sein, eine Anbindung an einen Bus zu ermöglichen. Durch diese Ausbildung kann insbesondere noch einmal die geringere Wartungsanfälligkeit verbessert werden, da mechanische Kontakte und Sensor im Wesentlichen vermieden werden. Besonders vorteilhaft ist auch, dass als mechanischer Kontaktschluss lediglich das Eindringen der Kontaktbrücke in den Kontaktnehmer notwendig ist.

Bei einer Weiterbildung der Erfindung ist die Elektronikeinheit zur Kommunikation mit einer Schalteinheit, insbesondere zur Übermittlung von Schaltzuständen und/oder Identifikationssignalen. Die Schalteinheit ist ein Bauteil, mit dem durch einen Schaltvorgang ein Leitung geöffnet oder geschlossen werden kann, ähnlich wie bei einem Relais bzw. Schütz. Der Schaltvorgang wird jedoch dann ausgelöst, wenn von den Sensoren ein entsprechendes Signal bzw. eine entsprechende Information an den die Schalteinheit weitergegeben wird. Vorteilhaft ist insbesondere, dass die Leitung zwischen Schalteinheit und Sensor nicht mehr unterbrochen werden muss, wie es zum Beispiel regelmäßig bei einem Schütz / Relais der Fall ist.

Die Elektronikeinheit kann insbesondere im bzw. am Kontaktnehmer angeordnet sein, in dem auch Sender und Empfänger angeordnet sind. Der Kontaktnehmer kann in der Aufzugvorrichtung z.B. statisch angeordnet sein, während die Kontaktbrücke an einem beweglichen Teil angeordnet ist und lediglich den "Schlüssel" darstellt, um die Signalübertragung in dem Kontaktnehmer zu ermöglichen.

Bei einer besonders bevorzugten Weiterbildung der Erfindung sind genau zwei Anschlüsse vorhanden, die zum einen der Stromversorgung und zum anderen der Kommunikation mit der Elektronikeinheit dienen. Zur Kommunikation dient also die gleiche Leitung, die auch zur Stromversorgung verwendet wird. Diese Maßnahme ermöglicht eine besonders kompakte und kostengünstige Bauweise. Zudem wird ermöglicht, dass bei einer Nachrüstung, wenn z.B. ein herkömmlicher Sensor durch einen Sensor gemäß der Erfindung ausgetauscht wird, keine zusätzlichen Leitungen bzw. Anschlüsse verlegt werden müssen. Diese Maßnahme ermöglicht insbesondere eine gute Nachrüstbarkeit.

Ferner kann bei einer Ausführungsform der Erfindung die Kommunikation über eine Modulation seines Eigenwiderstandes des Sensors erfolgen. Im Stromkreis mit der Schalteinheit kann dadurch je nach Schaltung die Spannung und/oder der Stromstärke moduliert werden. Diese Modulation trägt dann die Information, die bei der Kommunikation übertrager, werden soll. Denkbar ist z.B. ein Stromkreis, der in Reihe geschaltete Sensoren und (ebenfalls in Reihe geschaltet) eine Schalteinheit umfasst. Wird der Widerstand eines Sensors bei in Reihe geschalteten Sensoren verändert, so ändert sich die Stromstärke. Wir z.B. eine Konstantstromquelle für den Stromkreis verwendet, so bewirkt eine Änderung des Widerstandes, dass die Spannung erhöht werden muss, um die sich ergebende Abnahme der Stromstärke, die durch den geringeren Widerstand zunächst verursacht wird, auszugleichen. Die Modulation kann also Träger der Information sein. Die Änderungen von Stromstärke bzw. Spannung sind messbar und können als Information interpretiert werden.

Insbesondere ist der Sensor zur Verwendung in Reihenschaltung vorgesehen. Bei einer Reihenschaltung ist es insbesondere vorteilhaft, wenn der Sensor einen niedrigen Durchgangswiderstand aufweist. Der Widerstand eines Sensors kann beispielsweise im Bereich von größer als 0 Ohm bis 100 Ohm, insbesondere im Bereich von größer als 0 Ohm bis 20 Ohm, vorzugsweise als 10 Ohm, insbesondere kleiner als 5 Ohm liegen. Gerade bei einer Reihenschaltung ist es vorteilhaft, den Durchgangswiderstand möglichst klein, insbesondere kleiner als 5 Ohm auszulegen, damit keine zu hohe Spannung über dem Sensor abfällt.

Dementsprechend zeichnet sich ferner eine Sicherungsvorrichtung für Aufzugvorrichtungen, die über einen Antrieb eine Kabine verfahren können, mit einer Unterbrechungsvorrichtung zum Unterbrechen des Antriebs und mit wenigstens einem Sensor, der in Abhängigkeit vom Schließzustand der Aufzugstür zwischen wenigstens zwei Schaltzuständen schaltbar ist, und wobei die Unterbrechungsvorrichtung dazu ausgebildet ist, in Abhängigkeit vom Schaltzustand des wenigstens einen Sensors den Antrieb zu unterbrechen und/oder fortzusetzen, dadurch aus, dass ein Sensor gemäß der Erfindung eingesetzt wird. Die Unterbrechungsvorrichtung dient zum Unterbrechen des Antriebs, wobei die Unterbrechung davon abhängt, wie die Schaltzustände der entsprechenden Sensor sind, dass heißt davon, ob tatsächlich alle Türen verriegelt sind. Durch diese Maßnahme kann entsprechend die Wartungsanfälligkeit verbessert und die Sicherheit des Aufzugs erhöht werden.

Die Unterbrechungseinheit kann beispielsweise auch als Schalteinheit ausgebildet sein, die eine Kommunikationseinheit aufweist, um bei einem entsprechenden Signal des Sensors einen Schaltvorgang durchführen zu können.

Sind mehrere Türen vorhanden, so kann die Fahrt nur begonnen oder fortgesetzt werden, wenn alle Türen verriegelt sind. Dementsprechend ist es zweckmäßig, wenn die entsprechenden Sensoren, welche jeweils einer Tür zugeordnet sind, in Serie geschaltet sind.

Um etwa im Fall einer Blockade einer Tür oder im Falle eines Defekts feststellen zu können, welcher Sensor betroffen ist, ist es vorteilhaft, eine Anzeigevorrichtung vorzusehen, welche den Schaltzustand der einzelnen Sensoren anzeigt und gleichzeitig, die Zuordnung zu den einzelnen Sensoren ermöglicht.

Ferner wird eine Aufzugvorrichtung beansprucht, die eine Sicherungsvorrichtung gemäß der Erfindung umfasst.

### Ausführungsbeispiel:

Ausführungsbeispiele der Erfindung sind in den Zeichnungen dargestellt und werden nachstehend unter Angabe weiterer Einzelheiten und Vorteile näher erläutert.

Im Einzelnen zeigen:
- Figur 1: einen Sensor aus Kontaktbrücke mit Reflexionsstreifen und Kontaktnehmer gem. der Erfindung,
- Figur 2: ein Kontaktnehmer gem. der Erfindung,
- Figur 3: eine Kontaktbrücke mit Reflexionsstreifen gem. der Erfindung,
- Figur 4: einen Sensor aus Kontaktbrücke mit Lichtleiter und Kontaktnehmer gem. der Erfindung,
- Figur 5: ein Kontaktnehmer gem. der Erfindung, wie in Figur 2,
- Figur 6: eine Kontaktbrücke mit Lichtleiter gem. der Erfindung,
- Figur 7: das Verbinden (zeitlicher Ablauf) von Kontaktbrücke und Kontaktnehmer gem. der Erfindung,
- Figur 8: einen Sensor mit Reflexionsstreifen gem. der Erfindung,
- Figur 9: eine Sicherungsvorrichtung mit Sensoren gem. der Erfindung,
- Figur 10: eine Sicherungsvorrichtung mit Sicherheitskreis gem. der Erfindung,
- Figur 11: eine Sicherungsvorrichtung mit Bus gem. der Erfindung,
- Figur 12: eine Sicherungsvorrichtung mit Bus und integriertem Schütz in der Schalteinheit gem. der Erfindung,
- Figur 13: ein Schaltplan für einen Aufzug gem. der Erfindung,
- Figur 14: einen Sensor mit Lichtleitern gem. der Erfindung,
- Figur 15: eine perspektivische Ansicht des Sensors gem. Figur 14, sowie
- Figur 16: eine schematische Darstellung, wie in einer Sicherungsvorrichtung gem. der Erfindung die Kommunikation mit einzelnen Sensoren stattfindet.

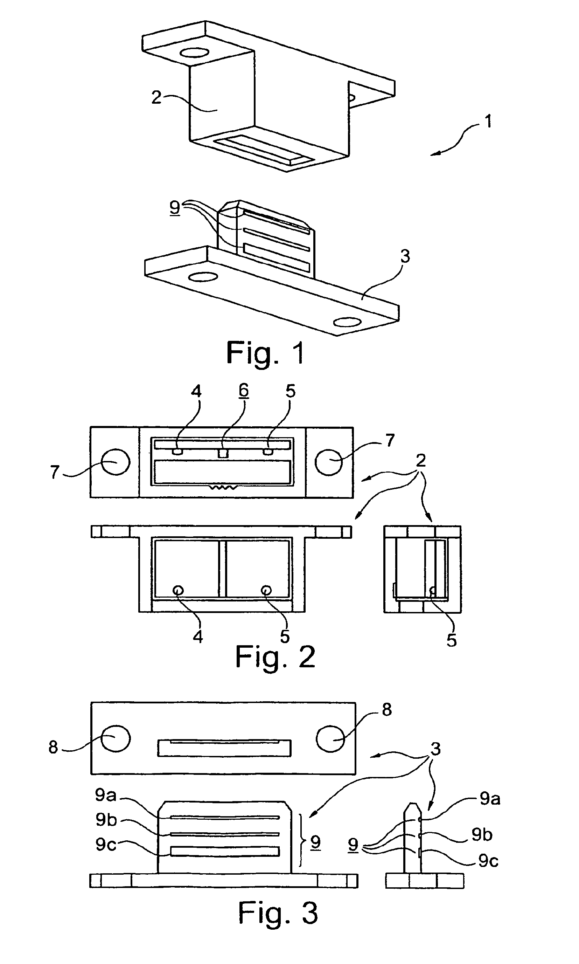

Figur 1 zeigt einen Sensor 1 mit einem Kontaktnehmer 2 (Schacht) und einer Kontaktbrücke 3, wobei die Kontaktbrücke Reflexionsstreifen 9 aufweist, die von einem Sender des Kontaktnehmers 2 ausgestrahltes Licht in Richtung eines Empfängers des Kontaktnehmers 2 reflektieren.

Figur 2 zeigt wiederum den entsprechenden Kontaktnehmer 2 mit einem Sender 4 und einem Empfänger 5, zwischen denen ein Trennsteg 6 angeordnet ist, und zwar in Vorderansicht, Seitenansicht und Draufsicht. Mit dem Bezugszeichen 7 sind Montagevorrichtungen bzw. Montagehilfen angegeben. Der Kontaktnehmer 2 weist zusätzliche elektrische Anschlüsse auf, über welche der Sensor 1 mit der restlichen Sensorvorrichtung bzw. nit dem Sicherheitskreis verbunden werden kann.

Figur 3 zeigt eine Kontaktbrücke in verschiedenen Ansichten und zwar in Vorderansicht, Seitenansicht und Draufsicht. Auch diese umfasst entsprechende Montagehilfen 8. Als Übertragungselemente 9 sind Schlitze in die Kontaktbrücke 3 eingearbeitet, die jeweils Reflexionsflächen aufweisen. Insgesamt gibt es drei Reflexionseinheiten 9a, 9b, 9c, sodass gewissermaßen eine dynamische Kontaktdetektion ermöglicht wird, da beim Eindringen der Kontaktbrücke 3 in den Kontaktnehmer 2 bzw. in den optischen Lichtweg zunächst die Reflexionseinheit 9a, danach die Reflexionseinheit 9b und schließlich 9c eindringen und somit eine dynamische Messung des Signals in zeitlicher Abhängigkeit möglich wird.

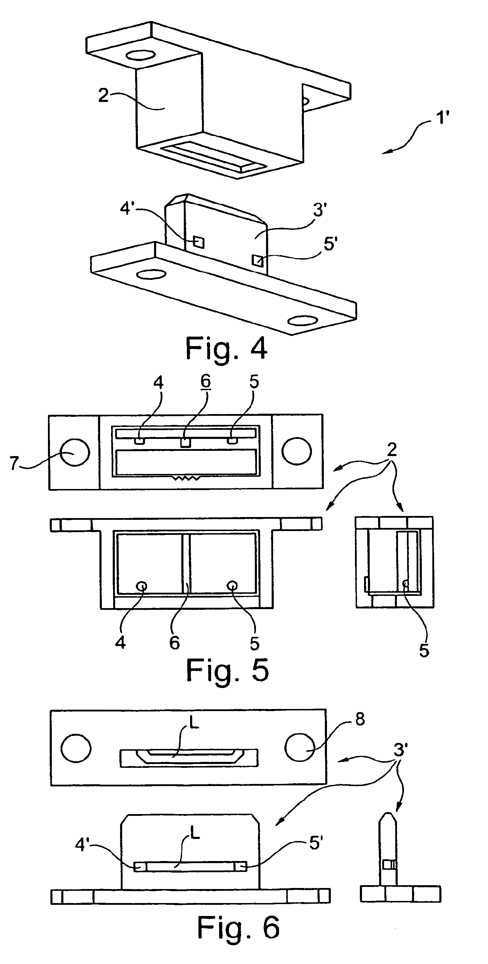

Figur 4 zeigt einen Sensor 1' mit einem Kontaktnehmer 2 (Schacht) und einer Kontaktbrücke 3', wobei die Kontaktbrücke einen Lichtleiter aufweist; das von einem Sender des Kontaktnehmers 2 ausgestrahltes Licht gelangt in den Lichtleitereingang 4', propagiert durch den Lichtleiter und tritt aus dem Lichtleiterausgang 5' wieder aus, sodass es in zum Empfänger des Kontaktnehmers 2 gelangt.

Figur 5 zeigt wiederum den entsprechenden Kontaktnehmer 2, wie er bereits zu Figur 2 beschrieben wurde, der auch für einen Sensor 1' mit Lichtleiter geeignet ist.

Figur 6 zeigt eine Kontaktbrücke 3' in verschiedenen Ansichten, und zwar in Vorderansicht, Seitenansicht und Draufsicht. Auch diese umfasst entsprechende Montagehilfen 8. Als Übertragungselement L ist ein Lichtleiter in die Kontaktbrücke 3' eingearbeitet, durch den das vom Kontaktnehmer ausgesendete Lichtsignal propagierten kann. Zu sehen sind auch der Lichteinlass 4' und der Lichtausgang 5'.

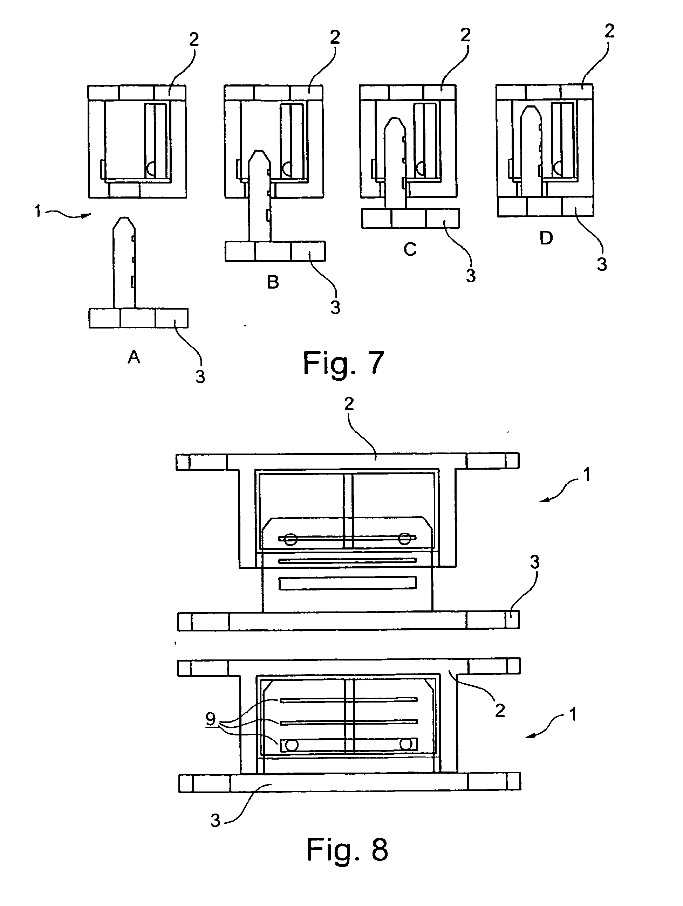

Figur 7 zeigt ein derartiges Eindringen der Kontaktbrücke 3 (mit Reflexionsstreifen) in den Kontaktnehmer 2, wobei in Situation A die Kontaktbrücke noch nicht in Verbindung mit dem Kontaktnehmer 2 steht. In Situation B ist die Reflexionseinheit 9a gerade im Bereich des optischen Weges eingedrungen und überträgt den Lichtweg vom Sender zum Empfänger. In Situation C steht die Kontaktbrücke 3 gerade so, dass eine Unterbrechung des optischen Signals erfolgt, da die Kontaktbrücke 3 in ihrer Höhe gerade zwischen den Reflexionseinheiten 9b und 9c steht und der optische Weg somit unterbrochen ist. Erst in Situation D steht die Kontaktbrücke, welche voll in den Kontaktnehmer 2 eingefahren ist, in einer derartigen Stellung, dass der optische Weg nicht unterbrochen ist und vom Empfänger 4 Licht über das Reflektionselement 9c in den Detektor/die Photodiode gelangen kann. Die Reflexionseinheiten 9, und auch sonstige Übertragungseinheiten wie optische Medien, können verschiedene Formen aufweisen und charakteristische Reflexionen oder Lichtübertragungen bieten, sodass diese jeweils mittels des Empfängers bzw. der Elektronikeinheit auch gegebenenfalls identifiziert werden können.

Figur 8 zeigt eine ähnliche Darstellung, bei der die Kontaktbrücke 3 in den Kontaktnehmer 2 eindringt.

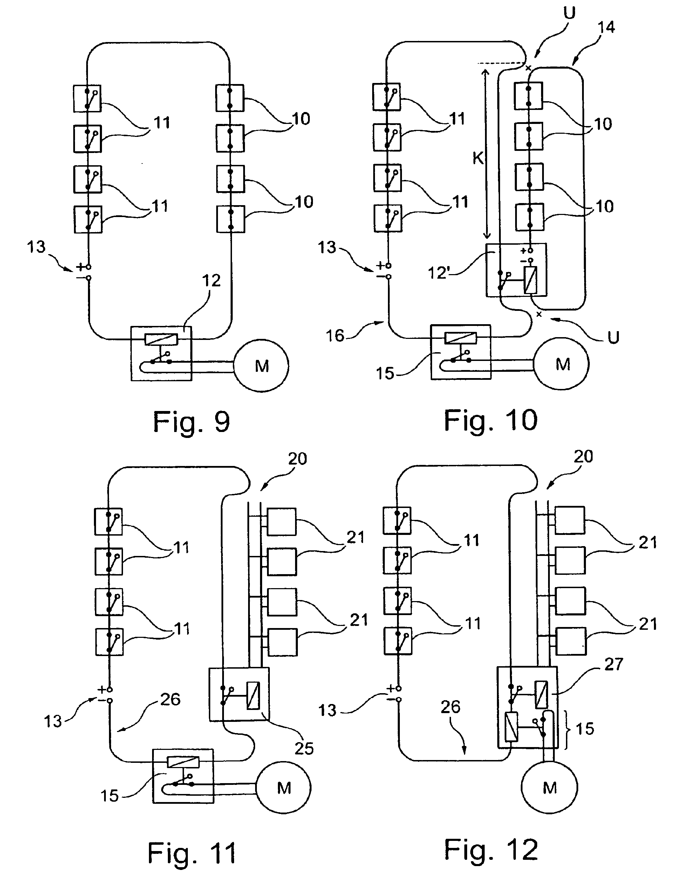

Figur 9 wiederum zeigt eine Sicherungsvorrichtung mit mehreren optischen Sensoren 10, welche alle in Serie geschaltet sind. Des Weiteren sind eine Reihe weiterer elektromechanischer Öffnungsschalter 11 vorhanden, welche in sonstiger Weise in Verbindung mit einem Aufzug verwendet werden können. Zudem ist eine Spannungsquelle 13 vorhanden. Alle diese Schalter bzw. Sensoren 11 und 10 sind in Serie geschaltet und mit einer Schalteinheit 12 verbunden. Dieser Stromkreis aus einer Reihenschaltung der Schalter 11, der Sensoren 10 und der Schalteinheit 12 bildet einen Sicherheitskreis. Ist einer der Schalter 11 unterbrochen, so ist der gesamte Stromkreis unterbrochen, und die Schalteinheit 12 schaltet den Motor M, der den Antrieb für die Aufzugskabine darstellt, ab. Die Schalter 11 können Öffnungsschalter bekannter Art sein. Detektiert einer der Sensoren 10, dass z.B. der Aufzug nicht ordnungsgemäß verriegelt ist, so sendet dieser ein entsprechendes Signal über den Schaltkreis, das von der Kommunikationseinheit der Schalteinheit 12 empfangen wird, sodass sie den Motor M abschalten kann. Dementsprechend übernimmt die Schalteinheit 12 teilweise die Funktion deines Relais; zusätzlich sind Schaltvorgänge der Schalteinheit aber auch abhängig von Signalen der Sensoren. Die Schalteinheit 12 reagiert also nicht nur auf Leitungsunterbrechungen.

Figur 10 zeigt eine Sicherungsvorrichtung mit einer Sicherheitseinrichtung, nämlich einem (zweiten) Sicherheitskreis 14, mit entsprechenden optischen Sensoren 10. Dieser Sicherheitskreis ist über eine Schalteinheit 12' mit dem ersten Sicherheitskreis 16 verbunden, der wiederum weitere Sensor 11 aufweist. Die Schalteinheit 12' ist ähnlich zu der Schalteinheit 12 und besitzt die gleiche Funktionsweise; vorliegend ist im Gegensatz zur Schalteinheit 12 aus Figur 9 jedoch die Spannungsquelle mit in der Schalteinheit 12' integriert. Im ersten Sicherheitskreis 16 befindet sich ein Schütz / Relais 15, welches wiederum einen Antrieb M ausschalten kann. Das Schütz 15 ist lediglich dazu ausgebildet, im Falle einer Leitungsunterbrechung des Kreises 16 den Motor M abzuschalten. Ist einer der Sensoren 10 optisch unterbrochen unterbrochen, so wird auch die Schalteinheit 12' unterbrochen und somit die Leitung des ersten Sicherheitskreises 16. Das Schütz 15 schaltet den Motor M ab. Anstelle der üblichen Öffnungsschalter sind die erfindungsgemäßen Sensoren in einem eigenen Sicherheitskreis 14 zusammengefasst und über die Schalteinheit 12' mit dem ursprünglichen, ersten Sicherheitskreis 16 verbunden. Der Sicherheitskreis 16 kann dabei zum Teil die Verkabelung der ursprünglichen Sicherungsvorrichtung verwenden.

In Figur 10 ist zudem dargestellt, wie eine Nachrüstung einer herkömmlichen Vorrichtung erfolgen kann, indem der ursprüngliche erste Sicherheitskreis 16 an den Stellen U gekappt wird und der zweite Sicherheitskreis 14 mit der Schalteinheit 12' entsprechend eingesetzt wird. Es muss dann nur ein längeres Kabel K eingezogen werden.

Figur 11 zeigt eine entsprechende Vorrichtung bei der statt eines zweiten Sicherheitskreises als Sicherungseinrichtung ein Bus 20 angeordnet ist. Die entsprechenden Sensor 21 weisen eine Elektronikeinheit auf, welche eine Verbindung zu dem entsprechenden Bus 20 ermöglichen. Der Bus ist ebenfalls an eine Schalteinheit 25 angeschlossen, sodass bei Unterbrechen eines der optischen Sensor 21 dieser wiederum ein Signal an die Schalteinheit 25 sendet, welche den ersten Sicherheitskreis 26 wiederum unterbricht. Mit dem Schütz 15 wird aufgrund der unterbrochenen Leitung des Sicherheitskreises 26 der Motor M abgeschaltet. Die Schalteinheit 25 kann z.B. den Master im Bus bilden, während die Sensoren 21 in Slave-Konfiguration vorliegen.

Figur 12 zeigt eine ähnliche Vorrichtung wie Figur 8, jedoch ist hier der Schütz 15 in die Schalteinheit 27 zusätzlich integriert, wobei das Schütz den Motor gegebenenfalls abschaltet.

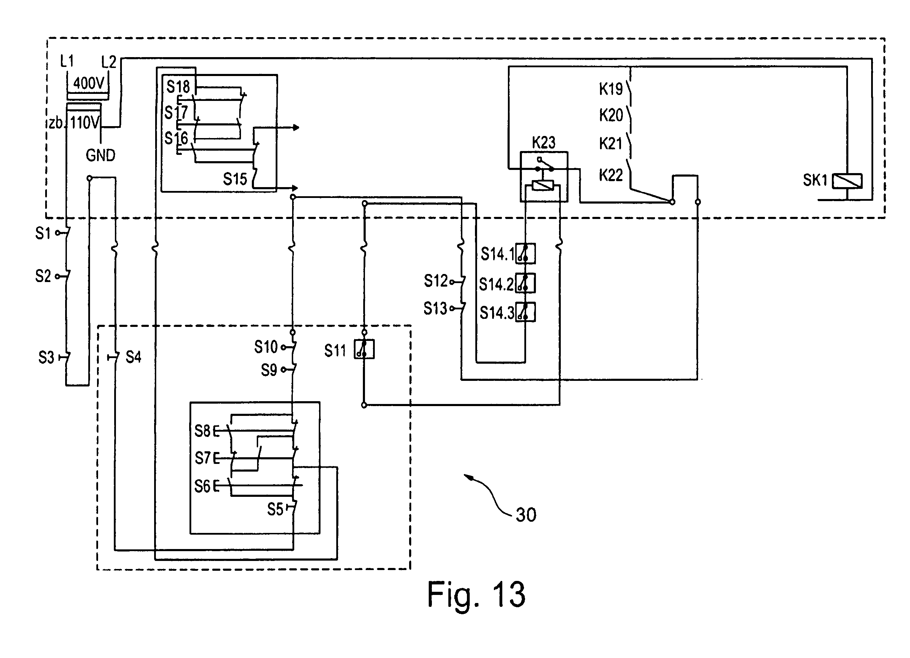

Figur 13 zeigt einen exemplarischen Schaltplan 30 für einen Aufzug gem. der Erfindung.

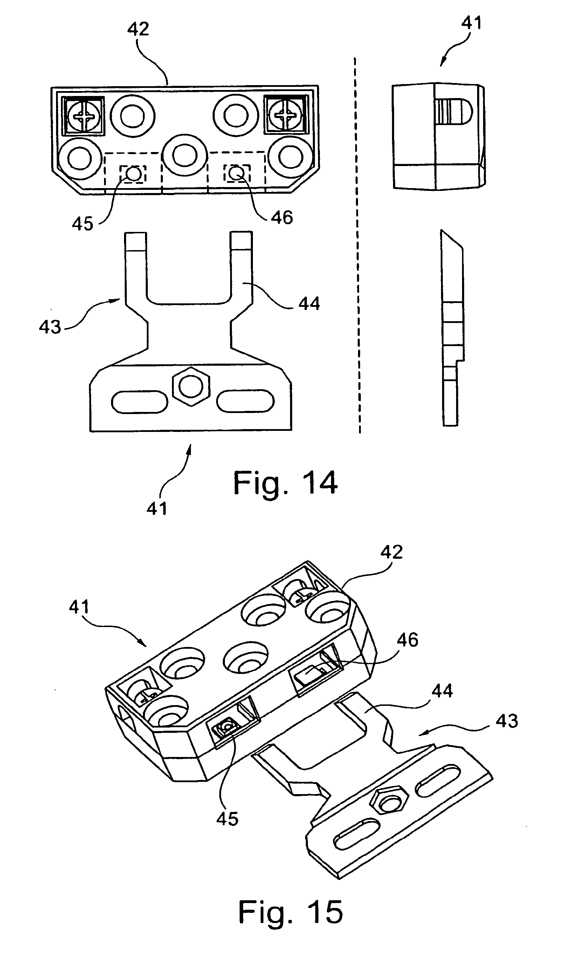

Figur 14 zeigt einen Sensor 41 in Draufsicht und in einer Seitenansicht mit einem Kontaktnehmer 42 und einer Kontaktbrücke 43, in welcher ein Lichtleiter 44 angeordnet ist. Vorliegend ist die Kontaktbrücke 43 insgesamt als Lichtleiter 44 ausgebildet, besteht also aus dem entsprechenden optischen Medium. Der Kontaktnehmer 42 umfasst einen Sender 45 und einen Empfänger 46 zum Senden / Empfangen von optischen Signalen. Das vom Sender 45 ausgesandte optische Signal kann, sobald der Kontaktnehmer 42 die Kontaktbrücke 43 aufgenommen hat, durch den Lichtleiter 44 propagieren und gelangt so in den Empfänger 46. Die Kontaktbrücke 43 (bzw. der Lichtleiter 44) ist U-förmig ausgebildet und greift, wenn sie in den Kontaktnehmer 42 gesteckt wird, lediglich mit den beiden Schenkeln in die beiden Schächte des Kontaktnehmers 42 ein. Der Lichtleiter 44 ist dementsprechend ebenfalls U-förmig ausgebildet. Figur 15 wiederum zeigt den Sensor 41 in einer perspektivischen Ansicht.

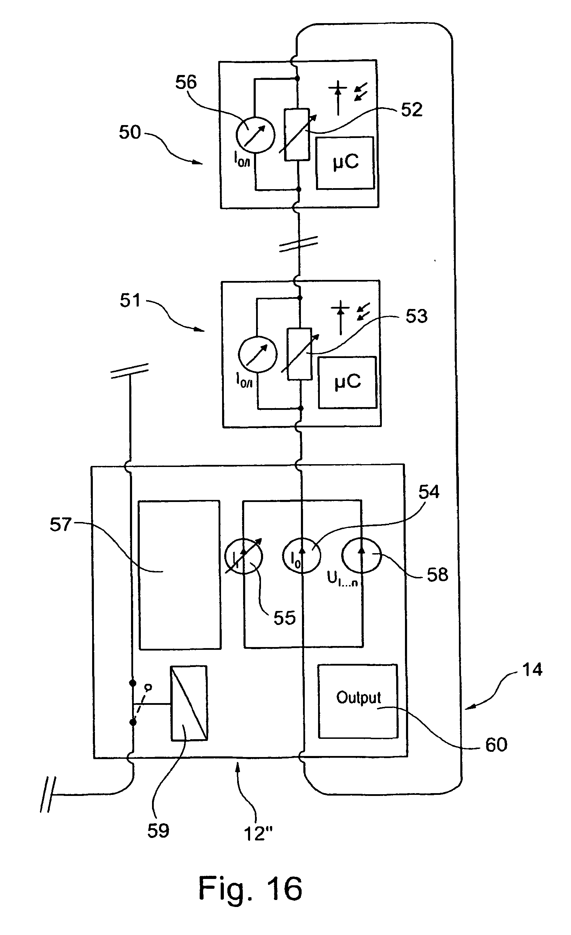

Figur 16 zeigt eine schematische Darstellung der Kommunikation im Sicherheitskreis 14 zwischen dem Controller 57 der Schalteinheit und den einzelnen Sensoren 10 bzw. deren Mikrocontrollern µC dar. Die Kommunikation vom Controller 57 zu den einzelnen Sensoren erfolgt über eine Strommodulation, während umgekehrt vom Sensor 10 zum Controller 57 eine Spannungsmodulation erfolgt.

Regelmäßig ist es erforderlich, dass deutliche Strom- bzw. Spannungsänderungen bzw. -modulationen erfolgen, da wegen der in Aufzugsystem vorkommenden großen Kabellängen die Änderung sonst unmerklich wäre. Zum Beispiel sind Stromänderungen im Bereich von Faktor 3 denkbar.

Die Einheiten 50, 51 entsprechen jeweils einem Sensor. Mit den Bezugszeichen 52, 53 sind veränderbare Widerstände dargestellt. Jedem Sensor ist ein veränderbarer Widerstand zugeordnet. Die Veränderung des Widerstandes kann auf verschiedene Art und Weise erfolgen: Denkbar ist, dass parallel Widerstände zu anderen hinzugeschaltet werden, wodurch sich der Gesamtwiderstand entsprechend verringert. Es ist aber auch denkbar, dass schaltungstechnisch, etwa durch Sperren einzelner Transistoren, der Widerstand beeinflusst wird. Die Veränderung des Widerstandes kann optisch beeinflusst werden, z.B. durch Phototransistoren, Photodioden, Optokoppler o. Ä.

Der Stromkreis umfasst Konstantstromquellen 54, 55, die jeweils dazu ausgebildet sind, ihre Spannung bei sich veränderndem Widerstand im Stromkreis so anzupassen, dass ein konstanter Strom fließt. Änderung des Widerstandes (Kommunikation: Controller 57 an Sensor 10) reguliert die Konstantstromquelle 54 auf eine konstante Stromstärke, sodass die über das Spannungsmessgerät 56 gemessene Spannung sich ändert.

Wird eine weitere Konstantstromquelle 55 hinzugeschaltet, so kann auch die Stromstärke moduliert werden, d.h. die Spannung bleibt nicht konstant (Kommunikation: Sensor an Controller). Die Änderung der an den Stromkreis angelegten Spannung kann durch das Spannungsmessgerät 58 ermittelt werden.

Über einen Ausgang 60 können somit die Zustände der einzelnen Sensoren oder sonstige Daten der Sensoren ausgegeben werden. Über den Mikrocontroller 57 wird entsprechend den Sensoren das Relais 59 gesteuert.

In Figur 16 ist eine Schalteinheit 12'' dargestellt, wie z.B auch in Figur 9 als Schalteinheit 12 oder in Figur 10 als Schalteinheit 12' dargestellt ist. Die Schalteinheit 12' umfasst noch eine Spannungsquelle. Die Schalteinheit 12 aus Figur 9 umfasst insbesondere noch die Funktion eines Relais, das bei Leitungsunterbrechung auch den Motor M abschalten kann. Die Schalteinheit 12 ist in Figur 16 mit einem (zweiten) Sicherheitskreis 14 verbunden.

### Bezugszeichenliste:

- 1: Sensor
- 1': Sensor
- 2: Kontaktnehmer
- 3: Kontaktbrücke
- 3': Kontaktbrücke
- 4: Sender
- 4': Lichtleitereingang
- 5: Empfänger
- 5': Lichtleiterausgang
- 6: Trennsteg
- 7: Montageeinheit
- 8: Montageeinheit
- 9: Reflexionsfläche
- 9a: Reflexionsfläche
- 9b: Reflexionsfläche
- 9c: Reflexionsfläche
- 10: optischer Sensor
- 11: elektromechanischer Öffnungsschalter
- 12: Schalteinheit
- 12': Schalteinheit (mit Spannungsquelle)
- 12'': Schalteinheit
- 13: Spannungsquelle
- 14: Zweiter Sicherheitskreis
- 15: Schütz / Relais
- 16: Erster Sicherheitskreis
- 20: Bus
- 21: Optischer Sensor mit Elektronikeinheit
- 25: Schalteinheit
- 26: Sicherheitskreis
- 27: Schalteinheit mit integriertem Schütz
- 30: Schaltplan
- 41: Sensor
- 42: Kontaktnehmer
- 43: Kontaktbrücke
- 44: Lichtleiter
- 45: Sender
- 46: Empfänger
- 50: Kommunikationseinheit
- 51: Kommunikationseinheit
- 52: veränderbarer Widerstand
- 53: veränderbarer Widerstand
- 54: Konstantstromquelle
- 55: Konstantstromquelle
- 56: Spannungsmessgerät
- 57: Mikrocontroller der Schalteinheit
- 58: Spannungsmessgerät
- 59: Relais
- 60: Ausgang
- A: Ansicht zu erstem Zeitpunkt
- B: Ansicht zu zweitem Zeitpunkt
- C: Ansicht zu drittem Zeitpunkt
- D: Ansicht zu viertem Zeitpunkt
- K: Kabel / Stromleitung
- L: Lichtleiter
- M: Antriebsmotor
- µC: Mikrocontroller eines Sensors
- U: Unterbrechung

## Patentansprüche

1. Sensor (1, 1', 10, 21, 41) für Sicherungsvorrichtungen für Aufzugvorrichtungen, die über einen Antrieb (M) eine Kabine verfahren können, wobei der Sensor eine Kontaktbrücke (3, 3', 43) und einen Kontaktnehmer (2) zur Aufnahme der Kontaktbrücke umfasst, welche so angeordnet sind, dass der Schließzustand der Aufzugstür durch Verbindung von Kontaktnehmer und Kontaktbrücke bestimmbar ist, wobei der Sensor als optischer Sensor ausgebildet ist, der einen Sender (4, 45) zum Senden eines optischen Signals und einen Empfänger (5, 46) zum Empfangen des optischen Signals umfasst, wobei der Sender und der Empfänger am Kontaktnehmer angeordnet sind und die Kontaktbrücke wenigstens ein Übertragungselement (9; 9a, 9b, 9c; 44, L) zur Übertragung des optischen Signals umfasst **dadurch gekennzeichnet, dass** die Kontaktbrücke dazu ausgebildet ist, in den Kontaktnehmer einzudringen und wobei der Kontaktnehmer wenigstens einen Schacht und die Kontaktbrücke wenigstens eine zungenförmige Lasche umfasst, welche bei Verbindung von Kontaktbrücke und Kontaktnehmer in den Schacht eingreift,

2. Sensor nach einem der vorgenannten Ansprüche, **dadurch gekennzeichnet, dass** das Übertragungselement als Reflexionsfläche (9; 9a, 9b, 9c) ausgebildet ist.

3. Sensor nach einem der vorgenannten Ansprüche, **dadurch gekennzeichnet, dass** das Übertragungselement als optisches Medium (44, L) ausgebildet ist.

4. Sensor nach einem der vorgenannten Ansprüche, **dadurch gekennzeichnet, dass** der Sender als Leuchtdiode und/oder der Empfänger als Photodiode ausgebildet sind /ist.

5. Sensor nach einem der vorgenannten Ansprüche, **dadurch gekennzeichnet, dass** zwischen Sender und Empfänger ein Trennelement (6) zur optischen Trennung von Sender und Empfänger angeordnet ist.

6. Sensor nach einem der vorgenannten Ansprüche, **dadurch gekennzeichnet, dass** die Kontaktbrücke U-förmig ausgebildet ist und der Kontaktnehmer zwei Schächte aufweist, sodass die Schenkel der U-förmigen Kontaktbrücke in die Schächte steckbar sind.

7. Sensor nach einem der vorgenannten Ansprüche, **dadurch gekennzeichnet, dass** wenigstens zwei Übertragungselemente vorgesehen sind, welche in Bewegungsrichtung der Kontaktbrücke hintereinander angeordnet sind.

8. Sensor nach einem der vorgenannten Ansprüche, **dadurch gekennzeichnet, dass** der Sensor eine Elektronikeinheit zur Auswertung des Empfängers umfasst, welche dazu ausgebildet ist, die Auswertung des Empfängers in einen der Schaltzustände und/oder in ein elektrisches Signal zu interpretieren.

9. Sensor nach einen der vorgenannten Ansprüche, **dadurch gekennzeichnet, dass** die Elektronikeinheit zur Kommunikation, insbesondere zur Übermittlung von Schaltzuständen und/oder Identifikationssignalen, mit einer Schalteinheit ausgebildet ist, wobei die Schalteinheit dazu ausgebildet ist, in Abhängigkeit von der Elektronikeinheit einen Schaltvorgang durchzuführen.

10. Sensor nach einem der vorgenannten Ansprüche, **dadurch gekennzeichnet, dass** die Elektronikeinheit im Kontaktnehmer angeordnet ist.

11. Sensor nach einem der vorgenannten Ansprüche, **dadurch gekennzeichnet, dass** genau zwei elektrische Anschlüsse vorhanden sind, die zur Stromversorgung und zur Kommunikation mit der Elektronikeinheit ausgebildet sind.

12. Sensor nach einem der vorgenannten Ansprüche, **dadurch gekennzeichnet, dass** der Sensor dazu ausgebildet ist, zur Kommunikation mit der Schalteinheit eine Modulation seines Eigenwiderstandes vorzunehmen.

13. Sensor nach einem der vorgenannten Ansprüche, **dadurch gekennzeichnet, dass** der Sensor zum Anschluss in Serienschaltung in einen Sicherheitskreis ausgebildet ist.

14. Sicherungsvorrichtung für Aufzugvorrichtungen, die über einen Antrieb eine Kabine verfahren können, mit einer Unterbrechungsvorrichtung (12) zum Unterbrechen des Antriebs, und mit wenigstens einem Sensor, der in Abhängigkeit vom Schließzustand der Aufzugstür zwischen wenigstens zwei Schaltzuständen schaltbar ist, und wobei die Unterbrechungsvorrichtung dazu ausgebildet ist, in Abhängigkeit vom Schaltzustand des wenigstens einen Sensors den Antrieb zu unterbrechen und/oder fortzusetzen, **dadurch gekennzeichnet, dass** der Sensor als Sensor nach einem der vorgenannten Ansprüche ausgebildet ist.

15. Sicherungsvorrichtung nach Anspruch 14, **dadurch gekennzeichnet, dass** wenigstens zwei Sensoren vorgesehen sind, wobei die Sensoren in Serie geschaltet sind.

16. Sicherungsvorrichtung nach Anspruch 14 oder 15, **dadurch gekennzeichnet, dass** eine Anzeigevorrichtung zur Anzeige des Schaltzustandes der einzelnen Sensoren mit Zuordnung der einzelnen Schaltzustände zu den entsprechenden Sensoren vorhanden ist.

17. Aufzugvorrichtung nach einem der vorgenannten Ansprüche, **dadurch gekennzeichnet, dass** eine Sicherungsvorrichtung nach einem der vorgenannten Ansprüche 14-16 vorgesehen ist.

## Claims

1. Sensor (1, 1', 10, 21, 41) for safety devices for elevator devices, which can move a cab by means of a drive (M), the sensor comprising a contact bridge (3, 3', 43) and a contact receiver (2) for receiving the contact bridge, said contact bridge being arranged in such a way that the closing position of the elevator door can be determined by connecting the contact receiver and the contact bridge, wherein the sensor is in the form of an optical sensor which comprises a transmitter (4, 45) for transmitting an optical signal and a receiver (5, 46) for receiving the optical signal, wherein the transmitter and the receiver are arranged on the contact receiver and the contact bridge comprises at least one transmission element (9; 9a, 9b, 9c; 44, L) for transmitting the optical signal, **characterised in that** the contact bridge is configured to enter into the contact receiver and wherein the contact receiver comprises at least one shaft and the contact bridge comprises at least one tongue-like tab which engages in the shaft during the connection of the contact bridge and contact receiver.

2. Sensor according to one of the preceding claims, **characterised in that** the transmission element is configured as a reflective surface (9; 9a, 9b, 9c).

3. Sensor according to one of the preceding claims, **characterised in that** the transmission element is configured as an optical medium (44, L).

4. Sensor according to one of the preceding claims, **characterised in that** the transmitter is configured as a light-emitting diode and/or the receiver is configured as a photodiode.

5. Sensor according to one of the preceding claims, **characterised in that** an isolating element (6) for optically isolating the transmitter and the receiver is arranged between the transmitter and the receiver.

6. Sensor according to one of the preceding claims, **characterised in that** the contact bridge is configured to be U-shaped and the contact receiver has two shafts, so that the arms of the U-shaped contact bridge can be fitted into the shafts.

7. Sensor according to one of the preceding claims, **characterised in that** at least two transmission elements are provided which are arranged behind one another in the direction of movement of the contact bridge.

8. Sensor according to one of the preceding claims, **characterised in that** the sensor comprises an electronic unit for evaluating the receiver, which electronic unit is designed to interpret the evaluation of the receiver into one of the switching states and/or into an electrical signal.

9. Sensor according to one of the preceding claims, **characterised in that** the electronic unit is designed for communication with a switching unit, in particular for transmitting switching states and/or identification signals, wherein the switching unit is designed to perform a switching operation as a function of the electronic unit.

10. Sensor according to one of the preceding claims, **characterised in that** the electronic unit is arranged in the contact receiver.

11. Sensor according to one of the preceding claims, **characterised in that** exactly two electrical terminals are provided, which are designed for supplying power and for communication with the electronic unit.

12. Sensor according to one of the preceding claims, **characterised in that** the sensor is designed to perform modulation of its internal resistance for communication with the switching unit.

13. Sensor according to one of the preceding claims, **characterised in that** the sensor is designed to connect in series in a safety circuit.

14. Safety device for lift devices which can move a cab by means of a drive, with an interrupting device (12) for interrupting the drive, and with at least one sensor, which can be switched between at least two switching states as a function of the closing position of the lift door, and wherein the interrupting device is configured to interrupt and/or continue the drive as a function of the switching state of the at least one sensor, **characterised in that** the sensor is designed as a sensor according to one of the preceding claims.

15. Safety device according to claim 14, **characterised in that** at least two sensors are provided, the sensors being connected in series.

16. Safety device according to claim 14 or 15, **characterised in that** a display device is provided for displaying the switching state of the individual sensors with allocation of the individual switching states to the corresponding sensors.

17. Lift device according to one of the preceding claims, **characterised in that** a safety device is provided according to one of the preceding claims 14 - 16.

## Revendications

1. Capteur (1, 1', 10, 21, 41) pour des dispositifs de sécurité pour des dispositifs d'ascenseur, pouvant déplacer une cabine par l'intermédiaire d'un entraînement (M), le capteur comprenant un cavalier de contact (3, 3', 43) et un récepteur de contact (2) destiné à recevoir le cavalier de contact, lesquels sont disposés de sorte que l'état de fermeture de la porte d'ascenseur peut être déterminé par la connexion du récepteur de contact et du cavalier de contact, le capteur étant conçu sous la forme d'un capteur optique comprenant un émetteur (4, 45) pour émettre un signal optique et un récepteur (5, 46) pour recevoir le signal optique, l'émetteur et le récepteur étant disposés sur le récepteur de contact et le cavalier de contact comprenant au moins un élément de transmission (9 ; 9a, 9b, 9c ; 44, L) pour transmettre le signal optique, **caractérisé en ce que** le cavalier de contact est conçu pour pénétrer dans le récepteur de contact et le récepteur de contact comportant au moins une cavité et le cavalier de contact comportant au moins une patte en forme de languette qui s'engage dans la cavité lorsque le cavalier de contact et le récepteur de contact sont connectés.

2. Capteur selon la ***revendication précédente,* caractérisé en ce que** l'élément de transmission est conçu sous la forme d'une surface réfléchissante (9 ; 9a, 9b, 9c).

3. Capteur selon l'une des revendications précédentes, **caractérisé en ce que** l'élément de transmission est conçu sous la forme d'un support optique (44, L).

4. Capteur selon l'une des revendications précédentes, **caractérisé en ce que** l'émetteur est conçu sous la forme d'une diode électroluminescente et/ou le récepteur est conçu sous la forme d'une photodiode.

5. Capteur selon l'une des revendications précédentes, **caractérisé en ce qu'**un élément séparateur (6) est disposé entre l'émetteur et le récepteur pour séparer optiquement l'émetteur et le récepteur.

6. Capteur selon l'une des revendications précédentes, **caractérisé en ce que** le cavalier de contact est conçu en forme de U et le récepteur de contact comprend deux cavités, de sorte que les branches du cavalier de contact en forme de U peuvent être introduites dans les cavités.

7. Capteur selon l'une des revendications précédentes, **caractérisé en ce qu'**au moins deux éléments de transfert sont prévus, disposés l'un derrière l'autre dans la direction de déplacement du cavalier de contact.

8. Capteur selon l'une des revendications précédentes, **caractérisé en ce que** le capteur comporte une unité électronique pour exploiter le récepteur, laquelle unité électronique est conçue pour interpréter l'exploitation du récepteur sous la forme d'un des états de commutation et/ou d'un signal électrique.

9. Capteur selon l'une des revendications précédentes, **caractérisé en ce que** l'unité électronique est conçue pour communiquer avec une unité de commutation, en particulier pour transmettre des états de commutation et/ou des signaux d'identification, l'unité de commutation étant conçue pour exécuter une opération de commutation en fonction de l'unité électronique.

10. Capteur selon l'une des revendications précédentes, **caractérisé en ce que** l'unité électronique est disposée dans le récepteur de contact.

11. Capteur selon l'une des revendications précédentes, **caractérisé en ce que** exactement deux raccords électriques sont prévus qui sont conçus pour l'alimentation en courant électrique et la communication avec l'unité électronique.

12. Capteur selon l'une des revendications précédentes, **caractérisé en ce que** le capteur est conçu pour exécuter une modulation de sa résistance interne en vue de la communication avec l'unité de commutation.

13. Capteur selon l'une des revendications précédentes, **caractérisé en ce que** le capteur est conçu pour être raccordé en série dans un circuit de sécurité.

14. Dispositif de sécurité pour des dispositifs d'ascenseur pouvant déplacer une cabine par l'intermédiaire d'un entraînement, avec un dispositif de coupure (12) pour interrompre l'entraînement, et avec au moins un capteur pouvant être commuté entre au moins deux états de commutation en fonction de l'état de fermeture de la porte d'ascenseur, et le dispositif de coupure étant conçu pour interrompre et/ou continuer l'entraînement en fonction de l'état de commutation du ou des capteurs, **caractérisé en ce que** le capteur est conçu sous la forme d'un capteur selon l'une des revendications précédemment.

15. Dispositif de sécurité selon la revendication 14, **caractérisé en ce qu'**au moins deux capteurs sont prévus, les capteurs étant montés en série.

16. Dispositif de sécurité selon la revendication 14 ou 15, **caractérisé en ce qu'**il est prévu un dispositif d'affichage pour afficher l'état de commutation des différents capteurs en affectant les différents états de commutation aux capteurs correspondants.

17. Dispositif d'ascenseur selon l'une des revendications précédentes, **caractérisé en ce qu'**il est prévu un dispositif de sécurité selon l'une des revendications 14-16.
